# EUROPÄISCHE PATENTSCHRIFT

(11) **EP 1 172 862 B1**
(45) Veröffentlichungstag und Bekanntmachung des Hinweises auf die Patenterteilung: **30.08.2006**
(21) Anmeldenummer: 00810603.1
(22) Anmeldetag: 10.07.2000
(51) Int. Cl.: H01L 29/861, H01L 21/263

(54) **Verfahren zum Herstellen einer Leistungsdiode**
Method of manufacturing a power diode
Méthode de fabrication d'une diode de puissance

(43) Veröffentlichungstag der Anmeldung: 16.01.2002
(73) Patentinhaber: ABB Schweiz AG, 5400 Baden (CH)
(72) Erfinder: Galster, Norbert, Dipl.-Ing., 5102 Rupperswil (CH)
(74) Vertreter: ABB Patent Attorneys

(56) Entgegenhaltungen:
- EP-A- 0 878 849
- DE-A- 4 337 329
- DE-A- 19 609 244
- US-A- 4 281 336
- PATENT ABSTRACTS OF JAPAN vol. 1996, no. 08, 30. August 1996 (1996-08-30) & JP 08 102545 A (MEIDENSHA CORP), 16. April 1996 (1996-04-16)

## Beschreibung

### TECHNISCHES GEBIET

Die vorliegende Erfindung bezieht sich auf das Gebiet der Leistungselektronik. Sie betrifft ein Verfahren zum Herstellen einer schnellen Leistungsdiode mit weichem Erholverhalten ("soft recovery") gemäss dem Oberbegriff des Anspruchs 1

### STAND DER TECHNIK

Beim beschaltungslosen Kommutieren von schnellen, verlust- und zuverlässigkeitsoptimierten Dioden (d.h. Dioden mit einem Halbleitersubstrat, das sich durch eine geringe Si-Dicke und einen hohen Grundmaterialwiderstand auszeichnet), tritt, besonders bei niedrigen Vorströmen und hohen Spannungen, ein abrupter Abriss des Rückstroms, ein sog. "snap off', auf.

Wie mehrfach beschrieben, kann ein solcher "snap off' bzw. ein solches hartes Schaltverhalten mittels verschiedener Massnahmen zu höheren Spannungen, die oberhalb der im Betrieb auftretenden Spannungen liegen, verschoben werden. Dies wird erreicht durch ein axiales Profil der Trägerlebensdauer im Bauelement, welches z.B. durch Eindiffusion von Schwermetallatomen oder lonenbestrahlung (He++ oder H+) erzeugt wird.

So ist in der US-A-4,140,560 vorgeschlagen worden, durch Eindiffusion von Goldatomen in das Halbleitersubstrat einer schnellen Diode eine Goldkonzentration mit einem ausgeprägten Konzentrationsgradienten im Substrat zu erzeugen, der zu einem weichen Erholverhalten ("soft recovery") führt.

Der "snap off" wird zusätzlich durch eine niedrige effektive Ladungsträger-Lebensdauer, wie sie bei grossflächigen und auf geringe dynamische Verluste eingestellte Dioden nötig ist, noch begünstigt. Die Reduktion der Abschaltverluste durch Erhöhung der lonendosis ist bei rein ionenbestrahlten Dioden ausserdem durch den dadurch erzeugten hohen Sperrstrom im Bauelement limitiert.

Es führen folglich weder eine kombinierte Bestrahlung mit lonen und Elektronen noch eine Erhöhung der lonendosis zum Ziel.

Gemäss einem anderen bekannten Vorschlag (DE-A1-41 35 258) wird das Halbleitersubstrat einer schnellen Leistungsdiode durch eine spezielle partielle Behandlung (z.B. eine Bestrahlung mit Protonen oder Helium-Kernen und eine Elektronenbestrahlung) in zwei nebeneinanderliegende, separate Teilflächen unterteilt. Die auf diese Weise gebildeten Teildioden unterscheiden sich dadurch, dass die eine Teildiode ein weiches Erholverhalten hat, während die andere ein hartes "snap off'-Verhalten zeigt. Durch Parallelschaltung beider Teildioden ergibt sich das gewünschte Gesamtverhalten der Diode.

Es ist weiterhin vorgeschlagen worden (DE-A1-196 09 244), die beiden o.g. Teildioden dadurch auszubilden, dass in einer nicht bestrahlten oder einer Grundbestrahlung mit Elektronen ausgesetzten Fläche des Halbleitersubstrats verteilt Gebiete angeordnet sind, in denen eine Bestrahlung bzw. eine zusätzliche Bestrahlung vorgenommen worden ist. Zur Erzeugung der verteilten Gebiete wird beispielsweise eine streifenförmige Maske verwendet. Auf diese Weise wird zusätzlich zum axialen Profil der Trägerlebensdauer ein laterales Profil der Trägerlebensdauer erzeugt. Die Kombination beider Profile führt dann zum gewünschten Schaltverhalten der Diode.

In EP 0 878 849 wurde vorgeschlagen, ein Halbleitersubstrat einer Leistungsdiode mit Elektronen zu bestrahlen wobei auf das Halbleitersubstrat eine Lochmaske gelegt wird, so dass nur ein Teil des Substrats gestrahlt wird. Dadurch wird ein lateral inhomogene Trägerlebensdauerprofil erzeugt.

Die nach den bekannten Verfahren hergestellten schnellen Leistungsdioden mit "soft recovery"-Verhalten sind zwar im Schaltverhalten verbessert, weisen jedoch unerwünscht hohe Sperrströme bzw. Sperrverluste auf.

### DARSTELLUNG DER ERFINDUNG

Es ist daher Aufgabe der Erfindung, ein Verfahren zur Herstellung einer schnellen Leistungsdiode mit "soft recovery"-Verhalten anzugeben, welches zu Bauelementen mit niedrigen Sperrverlusten führt.

Die Aufgabe wird durch die Gesamtheit der Merkmale des Anspruchs 1 gelöst. Der Kern der Erfindung besteht darin, nach einer ganzflächigen lonenbestrahlung durch eine Maskierung des Bauelements während der nachfolgenden Elektronenbestrahlung eine dreidimensionale Lebensdauereinstellung zu schaffen. Man erhält dadurch im Prinzip zwei Dioden-Teilbereiche, die als parallel geschaltete Dioden mit unterschiedlichen dynamischen und statischen Eigenschaften verstanden werden können. Der Diodenteil mit hoher Bestrahlungsdosis (lonenbestrahlung + Elektronenbestrahlung) besitzt einen sehr hohen Leitungswiderstand und trägt praktisch keinen Vorwärtsstrom. Entsprechend ist sein Anteil an der gesamten Speicherladung der Diode niedrig. Der andere Teilbereich (Teil ohne Elektronenbestrahlung) trägt praktisch den ganzen Vorwärtsstrom und bestimmt die "recovery charge" und das Erholverhalten.

Aufgrund der damit stark reduzierten Aktivfläche ergeben sich erhöhte Stromdichten bei relativ hoher Trägerlebensdauer, was zu einem dementsprechend weichen Abrissverhalten führt. Die Bestrahlung mit Elektronen führt zu einer geringeren Erhöhung des Sperrstroms als die reine lonenbestrahlung auf einen vergleichbaren Vorwärtsspannungsabfall, so dass auch die Sperrverluste niedrig bleiben. Die reduzierte Aktivfläche führt auch dazu, dass es Teilbereiche der Diode gibt, die aufgrund der zusätzlichen Bestrahlung keinen oder nur einen reduzierten Vorwärtsstrom tragen und daher beim Abkommutieren der Diode keine oder nur geringe Schaltverluste erzeugen. Damit wird insgesamt der Bereich, in dem Abschaltverluste generiert werden, kleiner. Die erzeugte Verlustwärme wird aber nach wie vor über die gesamte Substratfläche verteilt nach aussen abgeführt. Bezogen auf die Aktivfläche der Diode wird dadurch eine Verringerung des thermischen Widerstands Rₜₕ erreicht.

Eine erste bevorzugte Ausgestaltung des Verfahrens nach der Erfindung zeichnet sich dadurch aus, dass für die zweite, maskierte Bestrahlung als Maske eine Lochplatte, vorzugsweise aus Stahl oder Molybdän, verwendet wird. Mit einer solchen Maske kann eine optimale Verteilung der Gebiete der beiden Teildioden erreicht werden.

Eine weitere Profilierung in lateraler Richtung kann erreicht werden, wenn gemäss einer zweiten bevorzugten Ausgestaltung der Erfindung für die zweite, maskierte Bestrahlung als Maske ein Gewebe, vorzugsweise aus Stahldraht, verwendet wird. Bei einer Beschleunigungsenergie für Elektronen von z.B. 2.5 MeV führt ein solches Gewebe bei einer Drahtdicke von 1 mm in den Knotenpunkten zur totalen Abschirmung und in den einfach abgedeckten Bereichen zu einer teilweisen Abschirmung, was zu einer begrenzten Eindringtiefe der Elektronen in das Silizium und damit zu einem zusätzlichen Defektprofil führt. In den nicht abgedeckten Bereichen findet die Bestrahlung mit voller Energie statt, was die Erzeugung einer axial konstanten Defektverteilung zur Folge hat.

Bevorzugt beträgt der durch die Maske nicht abgedeckte Flächenbereich zwischen 20% und 80%, vorzugsweise etwa 50%, der Gesamtfläche der Maske.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1: eine beispielhafte "Technologiekurve" (a), mit deren Hilfe Leistungsdioden charakterisiert werden können, wobei dynamische Schaltverluste (i.d.R. E_{off}) gegen statische Leitungsverluste aufgetragen sind;
- Fig. 2: in den Teilfiguren 2A bis 2D verschiedene Schritte bei Herstellungsverfahren gemäss zweier bevorzugter Ausführungsbeispiele der Erfindung;
- Fig. 3: die Stromverteilung in einer beispielhaften, nach der Erfindung hergestellten Diode mit 3D-Lebens-dauerprofil. Kurve (b) ist die Vorwärtskennlinie der Teildiode mit einer reinen Protonenbestrahlung. Kurve (c) ist der Diodenteil mit zusätzlicher Elektronenbestrahlung;
- Fig. 4: das Erholverhalten der Diode aus Fig. 3; Kurve (e) ist der Strom während des Abschaltens der Teildiode mit einer reinen Protonenbestrahlung. Kurve (d) ist der Diodenteil mit zusätzlicher Elektronenbestrahlung. Kurve (f) ist der Gesamtstrom; und
- Fig. 5: in einem vereinfachten Längsschnitt den beispielhaften Aufbau einer nach der Erfindung hergestellten Leistungsdiode mit ganzflächiger thermischer Kontaktierung der aktiven und deaktivierten Flächen.

### WEGE ZUR AUSFÜHRUNG DER ERFINDUNG

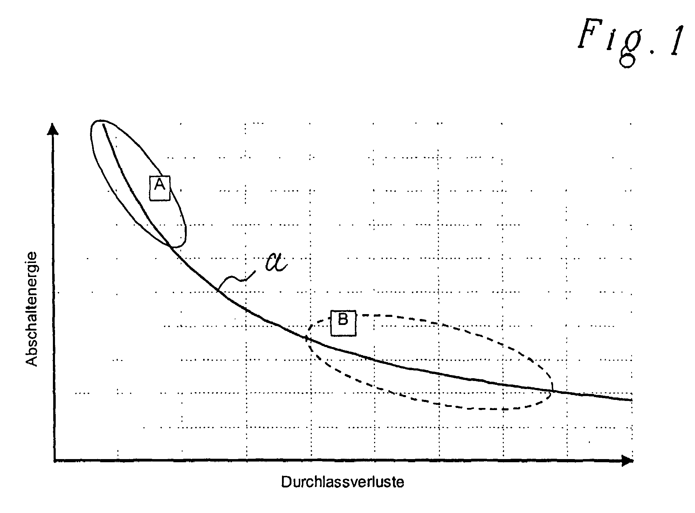

Leistungsdioden können mit Hilfe einer sog. "Technologiekurve" charakterisiert werden, d.h. es werden dynamische Schaltverluste (i.d.R. E_{off} bzw. Abschaltenergie) gegen statische Leitungsverluste (Durchlassverluste) aufgetragen. Eine solche Technologiekurve ist in Fig. 1 beispielhaft wiedergegeben.

Die Lage der Technologiekurve im Diagramm ist gegeben durch die Wahl des Silizium-Ausgangsmaterials (Durchmesser, Dicke und Resistivität) für das Halbleitersubstrat der Diode und die Art der Lebensdauereinstellung. Man erhält demnach verschiedene Technologiekurven für verschiedene Lebensdauertechnologien und verschiedene Si-Materialspezifikationen.

Die Lage einzelner Bauelemente auf einer dieser Technologiekurven wird bestimmt durch den Absolutwert der Trägerlebensdauer bei einer gegebenen Technologie. Um bei einem gegebenen Durchmesser und gegebener Si-Dicke und Si-Resistivität ein Bauelement auf der Technologiekurve vom Bereich "A" in den Bereich "B" (siehe Fig. 1) zu verschieben, muss die Trägerlebensdauer weiter reduziert werden. Dies kann erreicht werden durch (a) Erhöhung der Elektronenbestrahlungsdosis oder (b) zusätzliche Schwermetalldiffusion oder (c) zusätzliche lonenbestrahlung.

Methode (a) führt zu einer Diode mit tendenziell harten Erholeigenschaften beim Abschalten, während jedoch Methoden (b) und (c) zu hohem Leckstrom und damit hohen Sperrverlusten und im Extremfall Sperrbetriebsinstabilität führen.

Das Problem kann umgangen werden, indem die Lebensdauer einer Diode, deren qualitatives Schaltverhalten bereits durch eine lateral homogene Lebensdauereinstellung bestimmt ist, zusätzlich durch eine weitere maskierte Bestrahlung lateral strukturiert wird. Erfindungsgemäss wird die erste Einstellung in an sich bekannter Weise durch eine lonenbestrahlung vorgenommen, so dass ein axiales Lebensdauerprofil entsteht und die Diodeneigenschaften im Bereich "A" der Fig. 1 liegen. Durch eine zusätzliche laterale Strukturierung entsteht eine Diode mit einem dreidimensionalen (3D-)Lebensdauerprofil und elektrischen Eigenschaften im Bereich "B" der Technologiekurve, ohne dass die qualitativen Erholeigenschaften und die Sperrverluste signifikant beeinflusst werden. Die Diode kann dabei in zwei Teildioden eingeteilt werden, wobei der doppelt bestrahlte Teil (lonenbestrahlung + Elektronenbestrahlung) als elektrisch deaktiviert betrachtet werden kann.

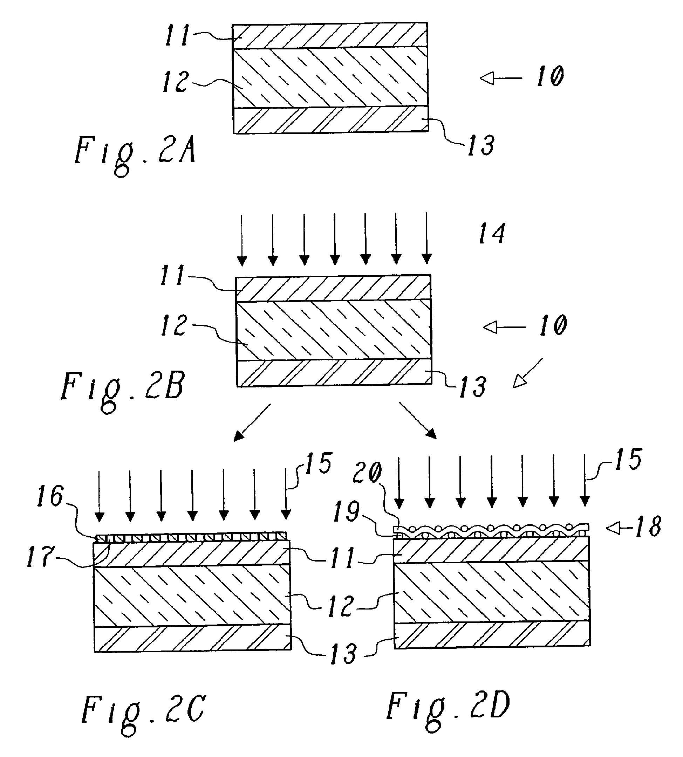

Die 3D-Lebensdauereinstellung wird durch eine Maskierung des Bauelements während der Elektronenbestrahlung erreicht. Die prinzipiellen Schritte des Verfahrens sind für zwei Alternativen in Fig. 2 dargestellt. Ausgangspunkt ist ein (flächiges) Halbleitersubstrat 10, in welchem durch geeignete Dotierverfahren mehrere Schichten 11, 12 und 13 unterschiedlicher Leitungsart und Dotierkonzentration erzeugt worden sind (Fig. 2A). Die Schicht 11 ist üblicherweise p-dotiert, die Schicht 12 n⁻-dotiert, und die Schicht 13 n⁺-dotiert.

In diesem Halbleitersubstrat 10 wird nun in einem ersten Schritt (Fig. 2B) durch eine unmaskierte lonenbestrahlung 14 ein axial (in Stromrichtung) veränderliches, lateral (quer zur Stromrichtung) jedoch homogenes Profil der Trägerlebensdauer erzeugt.

Anschliessend wird in einem nachfolgenden zweiten Schritt (Fig. 2C oder alternativ Fig. 2D) durch eine maskierte Elektronenbestrahlung 15 ein lateral inhomogenes Lebensdauerprofil erzeugt. Als Bestrahlungsmaske kann (in der Alternative der Fig. 2C) z.B. eine Lochplatte 16 aus Stahl oder Molybdän eingesetzt werden. In diesem Fall erhält man im Prinzip zwei Dioden-Teilbereiche, die als parallel geschaltete Dioden mit unterschiedlichen dynamischen und statischen Eigenschaften verstanden werden können. Der Diodenteil mit hoher Bestrahlungsdosis (Bereiche, die mit den Löchern 17 der Lochplatte 16 übereinstimmen) besitzt einen sehr hohen Leitungswiderstand und trägt praktisch keinen Vorwärtsstrom. Entsprechend ist sein Anteil an der gesamten Speicherladung der Diode niedrig. Der andere Teilbereich (Teil ohne Elektronenbestrahlung) trägt praktisch den ganzen Vorwärtsstrom und bestimmt die "recovery charge" und das Erholverhalten.

Aufgrund der damit stark reduzierten Aktivfläche ergeben sich erhöhte Stromdichten bei relativ hoher Trägerlebensdauer, was zu einem dementsprechend weichen Abrissverhalten führt. Die Bestrahlung mit Elektronen führt zu einer geringeren Erhöhung des Sperrstroms als die reine lonenbestrahlung auf einen vergleichbaren Vorwärtsspannungsabfall, so dass auch die Sperrverluste niedrig bleiben.

Eine weitere (laterale) Profilierung der Lebensdauer mittels Elektronenbestrahlung kann erreicht werden durch Verwendung anders ausgeführter Masken, wie z.B. einem Gewebe18 aus Stahldrähten 19, 20 mit definierter Maschenweite (Alternative der Fig. 2D). Bei einer Beschleunigungsenergie für Elektronen von z.B. 2.5 MeV führt ein solches Gewebe 18 bei einer Dicke der Stahldrähte 19, 20 von 1 mm in den Knotenpunkten zur totalen Abschirmung und in den einfach (von nur einem der Stahldrähte 19, 20) abgedeckten Bereichen zu einer teilweisen Abschirmung, was zu einer begrenzten Eindringtiefe der Elektronen in das Silizium und damit zu einem zusätzlichen Defektprofil führt. In den nicht abgedeckten Bereichen (zwischen den Drähten 19, 20) findet die Bestrahlung mit voller Energie statt, was die Erzeugung einer axial konstanten Defektverteilung zur Folge hat.

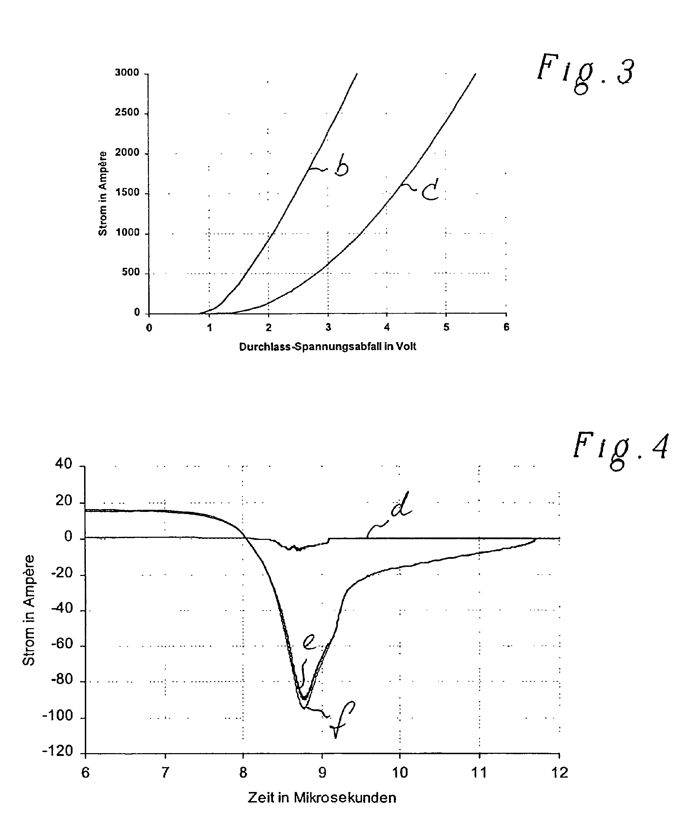

Das erfindungsgemässe Verfahren führt zu schnellen Leistungsdioden, deren elektrische Eigenschaften beispielhaft in den Fig. 3 und 4 anhand der Kurven der Teildioden dargestellt sind. Fig. 3 und 4 zeigen dabei die Stromaufteilung der beiden Teildioden bei einem Flächenverhältnis von 1:1 (zwischen einfach und zweifach bestrahlten Gebieten) für den Betrieb in Vorwärtsrichtung (Fig. 3) und während des Abschaltens (Fig. 4) für eine Diode mit ganzflächiger Protonenbestrahlung und einer maskierten zusätzlichen Elektronenbestrahlung. In Fig. 3 ist die Kurve (b) die Vorwärtskennlinie der Teildiode mit einer reinen Protonenbestrahlung. Kurve (c) charakterisiert den Diodenteil mit zusätzlicher Elektronenbestrahlung. Man erkennt, dass der Vorwärtsstrom der protonen- und elektronenbestrahlten Teildiode sehr viel geringer ist als der Vorwärtsstrom der rein protonenbestrahlten Teildiode.

Fig. 4 zeigt mit Kurve (e) den Strom während des Abschaltens der Teildiode mit einer reinen Protonenbestrahlung. Kurve (d) ist der Strom des Diodenteils mit zusätzlicher Elektronenbestrahlung. Kurve (f) zeigt den Gesamtstrom, d.h. die Summe der Ströme der beiden Teildioden.

Es versteht sich von selbst, dass die Diodeneigenschaften durch das Verhältnis der Teilflächen der beiden Teildioden zueinander beeinflusst werden können. Für praktische Anwendungen kann der elektrisch "deaktivierte" Teil (protonen- und elektronenbestrahlte Teildiode) 20% bis 80% der Gesamtfläche betragen. Dementsprechend ergibt sich auch die Art und Ausführung der Maske. Die Ausführung für eine Diode mit obigen Kennlinien (Flächenverhältnis: aktive Fläche zu Gesamtfläche von ca. 1:2) umfasst ein Stahlgewebe mit 1 mm Drahtdurchmesser und einer Maschenweite von 2 mm.

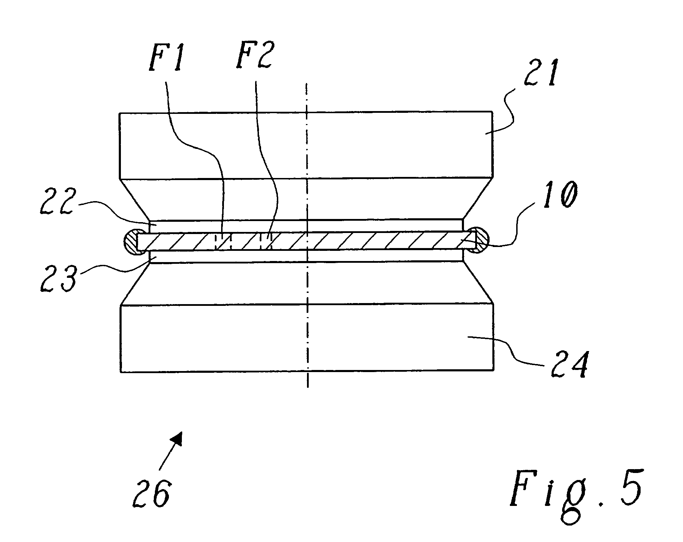

Die Aufteilung der Substratfläche in aktive und deaktivierte Teilbereiche bestimmt ausserdem die auf die Aktivfläche der Diode bezogene Verringerung des thermischen Widerstands Rₜₕ einer mit diesem Halbleitersubstrat 10 hergestellten Leistungsdiode 26, wie sie in Fig. 5 beispielhaft dargestellt ist. Das nach dem erfindungsgemässen Verfahren hergestellte Halbleitersubstrat 10 ist hier zwischen zwei Elektrodenscheiben 21, 24 (aus Cu) angeordnet, die - über ausgleichende Zwischenscheiben 22, 23 (aus Mo) - das Halbleitersubstrat 10 beidseitig ganzflächig elektrisch und thermisch kontaktieren. Das konzentrische Isoliergehäuse ist nicht gezeigt. Innerhalb des Halbleitersubstrats 26 gibt es nun verteilt Flächenbereiche F1, die zur Aktivfläche der Diode gehören, und Flächenbereiche F2, die aufgrund der zweiten Bestrahlung elektrisch deaktiviert sind (in Fig. 5 ist nur jeweils einer dieser Flächenbereiche beispielhaft dargestellt).

Die Teilbereiche der Diode, die aufgrund der zusätzlichen Bestrahlung keinen oder einen reduzierten Vorwärtsstrom tragen, erzeugen beim Abkommutieren der Leistungsdiode 26 keine bzw. nur reduzierte Schaltverluste. Damit wird der gesamte Bereich, in dem Abschaltverluste generiert werden, kleiner. Die erzeugte Verlustwärme wird aber nachwievor in dem gesamten Halbleitersubstrat 10 "verteilt" und über die Zwischenscheiben 22, 23 und die Elektrodenscheiben 21, 24 nach aussen geführt. Mit der maskierten Elektronenbestrahlung wird also die Aktivfläche, in der Schaltverluste erzeugt werden, reduziert; gleichzeitig bleibt aber die gesamte Fläche zur thermischen Weiterleitung der erzeugten Wärme nach aussen erhalten. Je nach (bei der Bestrahlung) abgedecktem Flächenbereich wird dadurch bezogen auf die Aktivfläche der Leistungsdiode 26 eine Verringerung des thermischen Widerstands Rₜₕ erreicht.

### BEZUGSZEICHENLISTE

- 10: Halbleitersubstrat
- 11,..,13: Schicht
- 14: lonenbestrahlung
- 15: Elektronenbestrahlung
- 16: Lochplatte (Maske)
- 17: Loch
- 18: Gewebe (Maske)
- 19,20: Stahldraht
- 21,24: Elektrodenscheibe (Cu)
- 22,23: Zwischenscheibe (Mo)
- 26: Leistungsdiode
- a-f: Kurve
- F1,F2: Flächenbereich

## Patentansprüche

1. Verfahren zum Herstellen einer schnellen Leistungsdiode (26) mit weichem Erholverhalten, bei welchem Verfahren die Trägerlebensdauer innerhalb des zugehörigen Halbleitersubstrats (10) durch eine erste, unmaskierte Bestrahlung (14) mit einem axialen Profil und durch eine nachfolgende zweite, maskierte Bestrahlung (15) mit einem lateralen Profil festgelegt wird, **dadurch gekennzeichnet, dass** die erste, unmaskierte Bestrahlung eine lonenbestrahlung (14) ist, durch welche das Schaltverhalten der Leistungsdiode (26) festgelegt wird, und dass die zweite, maskierte Bestrahlung eine Elektronenbestrahlung (15) ist, durch welche die Aktivfläche der Leistungsdiode (26) reduziert wird.

2. Verfahren nach Anspruch 1, **dadurch gekennzeichnet, dass** zur lonenbestrahlung Protonen oder He-lonen verwendet werden.

3. Verfahren nach einem der Ansprüche 1 und 2, **dadurch gekennzeichnet, dass** für die zweite, maskierte Bestrahlung (15) als Maske eine Lochplatte (16), vorzugsweise aus Stahl oder Molybdän, verwendet wird.

4. Verfahren nach einem der Ansprüche 1 und 2, **dadurch gekennzeichnet, dass** für die zweite, maskierte Bestrahlung (15) als Maske ein Gewebe (18), vorzugsweise aus Stahldraht (19, 20), verwendet wird.

5. Verfahren nach Anspruch 4, **dadurch gekennzeichnet, dass** das Gewebe aus Stahldraht (19, 20) besteht, und dass der Stahldraht (19, 20) eine Drahtdicke aufweist, derart, dass es bei gegebener Beschleunigungsenergie der Elektronen für die zweite Bestrahlung in den Knotenpunkten des Gewebes (18) zu einer totalen Abschirmung und in den von nur einem der Stahldrähte (19, 20) abgedeckten Bereichen zu einer teilweisen Abschirmung der Elektronenbestrahlung kommt.

6. Verfahren nach Anspruch 5, **dadurch gekennzeichnet, dass** der Stahldraht (19, 20) eine Drahtdicke von etwa 1 mm aufweist, und dass die Beschleunigungsenergie der Elektronen für die zweite Bestrahlung mehrere MeV, vorzugweise etwa 2,5 MeV, beträgt.

7. Verfahren nach einem der Ansprüche 3 bis 6, **dadurch gekennzeichnet, dass** der durch die Maske (16, 18) nicht abgedeckte Flächenbereich zwischen 20% und 80%, vorzugsweise etwa 50%, der Gesamtfläche der Maske (16, 18) beträgt.

## Claims

1. Method for producing a high-speed power diode (26) with soft recovery, in which method the carrier life within the associated semiconductor substrate (10) is governed by first, unmasked bombardment (14) with an axial profile and by subsequent, second, masked bombardment (15) with a lateral profile, **characterized in that** the first, unmasked bombardment is ion bombardment (14) which governs the switching response of the power diode (26) and **in that** the second, masked bombardment is electron bombardment (15), which reduces the active area of the power diode (26).

2. Method according to Claim 1, **characterized in that** protons or helium ions are used for ion bombardment.

3. Method according to one of Claims 1 or 2, **characterized in that** a perforated plate (16), preferably composed of steel or molybdenum, is used for the second, masked bombardment (15).

4. Method according to one of Claims 1 or 2, **characterized in that** a gauze (18), preferably composed of steel wire (19, 20), is used for the second, masked bombardment (15).

5. Method according to Claim 4, **characterized in that** the gauze is composed of steel wire (19, 20) and **in that** the steel wire (19, 20) has a wire thickness such that, for a given acceleration energy of the electrons for the second bombardment, said steel wire (19, 20) produces total shielding at the nodes in the gauze (18) and partial shielding of the electron bombardment in the areas which are covered by only one of the steel wires (19, 20).

6. Method according to Claim 5, **characterized in that** the steel wire (19, 20) has a wire thickness of approximately 1 mm, and **in that** the acceleration energy of the electrons for the second bombardment is several MeV, preferably approximately 2.5 MeV.

7. Method according to one of Claims 3 to 6, **characterized in that** the surface area which is not covered by the mask (16, 18) is between 20% and 80%, preferably approximately 50%, of the total area of the mask (16, 18).

## Revendications

1. Procédé pour fabriquer une diode de puissance rapide (26) ayant un comportement de rétablissement doux, procédé avec lequel la durée de vie des porteurs à l'intérieur du substrat semiconducteur (10) correspondant est déterminée par une première irradiation (14) non masquée avec un profilé axial et par une deuxième irradiation (15) masquée suivante avec un profilé latéral, **caractérisé en ce que** la première irradiation non masquée est une irradiation ionique (14) par laquelle est déterminé le comportement de commutation de la diode de puissance (26) et que la deuxième irradiation masquée est une irradiation électronique (15) par laquelle est réduite la surface active de la diode de puissance (26).

2. Procédé selon la revendication 1, **caractérisé en ce que** des protons ou des ions d'He sont utilisés pour l'irradiation ionique.

3. Procédé selon l'une des revendications 1 et 2, **caractérisé en ce que** le masque utilisé pour la deuxième irradiation (15) masquée est une plaque perforée (16) de préférence en acier ou en molybdène.

4. Procédé selon l'une des revendications 1 et 2, **caractérisé en ce que** le masque utilisé pour la deuxième irradiation (15) masquée est un tissu (18) de préférence en fil d'acier (19, 20).

5. Procédé selon la revendication 4, **caractérisé en ce que** le tissu se compose de fil d'acier (19, 20) et que le fil d'acier (19, 20) présente une épaisseur de fil telle qu'en présence d'une énergie d'accélération donnée des électrons pour la deuxième irradiation, il se produit dans les points nodaux du tissu (18) un blindage total contre l'irradiation électronique et un blindage partiel dans les zones recouvertes seulement par l'un des fils d'acier (19, 20).

6. Procédé selon la revendication 5, **caractérisé en ce que** le fil d'acier (19, 20) présente une épaisseur de fil d'environ 1 mm et que l'énergie d'accélération des électrons pour la deuxième irradiation est de plusieurs MeV, de préférence d'environ 2,5 MeV.

7. Procédé selon l'une des revendications 3 à 6, **caractérisé en ce que** la surface non recouverte par le masque (16, 18) est comprise entre 20 % et 80 %, de préférence égale à environ 50 % de la surface totale du masque (16, 18).
